(19) Europäisches Patentamt / European Patent Office / Office européen des brevets

(11) **EP 4 149 119 B1**

(12) **EUROPEAN PATENT SPECIFICATION**

(45) Date of publication and mention
of the grant of the patent:
**22.01.2025 Bulletin 2025/04**

(21) Application number: **21800553.6**

(22) Date of filing: **21.04.2021**

(51) International Patent Classification (IPC):
*H10N 30/85* (2023.01)   *H10N 30/88* (2023.01)
*H10N 30/092* (2023.01)   *H04R 17/00* (2006.01)
*H04R 31/00* (2006.01)

(52) Cooperative Patent Classification (CPC):
**H10N 30/883; H10N 30/092; H10N 30/852;**
H04R 17/005; H04R 31/003; H04R 2499/15

(86) International application number:
**PCT/JP2021/016180**

(87) International publication number:
**WO 2021/225075 (11.11.2021 Gazette 2021/45)**

(54) **PIEZOELECTRIC POLYMER FILM**

PIEZOELEKTRISCHE POLYMERFOLIE

FILM PIÉZOÉLECTRIQUE POLYMÈRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.05.2020 JP 2020082499**

(43) Date of publication of application:
**15.03.2023 Bulletin 2023/11**

(73) Proprietor: FUJIFILM Corporation
**Tokyo 106-8620 (JP)**

(72) Inventor: **NARUBAYASHI Misato
Minamiashigara-shi, Kanagawa 250-0193 (JP)**

(74) Representative: **Klunker IP
Patentanwälte PartG mbB
Destouchesstraße 68
80796 München (DE)**

(56) References cited:
WO-A1-2020/261822   WO-A1-2020/261954
JP-A- 2005 333 105   JP-A- 2010 053 022
JP-A- 2014 212 307   JP-A- 2014 535 168
US-A1- 2016 014 526   US-A1- 2018 014 096

• N. IZYUMSKAYA ET AL: "Processing, Structure, Properties, and Applications of PZT Thin Films", CRITICAL REVIEWS IN SOLID STATE AND MATERIALS SCIENCES, vol. 32, no. 3, 1 July 2007 (2007-07-01), pages 111 - 202, XP055135036, ISSN: 1040-8436, DOI: 10.1080/ 10408430701707347
• KOUR P ET AL: "Enhanced ferroelectric and piezoelectric properties in La-modified PZT ceramics", APPLIED PHYSICS A, SPRINGER BERLIN HEIDELBERG, BERLIN/HEIDELBERG, vol. 122, no. 6, 12 May 2016 (2016-05-12), pages 1 - 7, XP035683899, ISSN: 0947-8396, [retrieved on 20160512], DOI: 10.1007/S00339-016-0122-8

**Description**

**BACKGROUND OF THE INVENTION**

1. Field of the Invention

The present invention relates to a piezoelectric polymer film used for an electroacoustic conversion film that is used in a speaker, a microphone, or the like.

2. Description of the Related Art

Flexible displays, such as organic EL displays, which are formed of flexible substrates such as plastics have been developed.

In a case where such a flexible display is used as an image display device also serving as a sound generator that reproduces a sound together with an image, such as a television receiver, a speaker which is an acoustic device for generating a sound is required.

Here, examples of typical shapes of speakers of the related art include a funnel-like so-called cone shape and a spherical dome shape. However, in a case where such a speaker is intended to be incorporated in the above-described flexible display, there is a concern that the lightness and the flexibility, which are advantages of the flexible display, are impaired. Further, in a case where the speaker is attached externally, since the speaker is troublesome to carry and difficult to install on a curved wall, there is a concern that a beautiful appearance is impaired.

Under the above-described circumstances, a sheet-like piezoelectric polymer film with flexibility has been suggested as a speaker that can be integrated with a flexible display without impairing the lightness and the flexibility.

For example, JP2014-212307A describes a piezoelectric polymer film (electroacoustic conversion film) including a polymer-based piezoelectric composite material obtained by dispersing piezoelectric particles in a matrix consisting of a polymer material having a viscoelasticity at room temperature, and piezoelectric layers provided to sandwich the polymer-based piezoelectric composite material, in which an area fraction of piezoelectric particles in a contact surface with an electrode layer is 50% or less.

US 2016/014526 A1 relates to an electroacoustic transduction film formed by a piezoelectric polymer film. It comprises a piezoelectric layer between two electrode layers. The piezoelectric layer contains ceramics in a polymer matrix. The ceramics can be lead zirconate titanate.

WO 2020/261822 A1, WO 2020/261954 and US 2018/014096 A1 disclose similar piezoelectric polymer films.

**SUMMARY OF THE INVENTION**

The polymer-based piezoelectric composite material described in JP2014-212307A has excellent piezoelectric characteristics. In addition, since the polymer-based piezoelectric composite material is obtained by dispersing lead zirconate titanate particles in a polymer material containing cyanoethylated polyvinyl alcohol, the piezoelectric layer consisting of the polymer-based piezoelectric composite material has satisfactory flexibility.

Therefore, according to the piezoelectric polymer film formed of the polymer-based piezoelectric composite material, it is possible to obtain an electroacoustic conversion film or the like having flexibility and satisfactory piezoelectric characteristics, which can be used as, for example, a flexible speaker.

However, in recent years, requirements for piezoelectric characteristics of piezoelectric polymer films in which a piezoelectric layer is sandwiched between electrode layers, such as an electroacoustic conversion film, have been higher, and thus appearance of piezoelectric polymer films with excellent piezoelectric characteristics is desired.

An object of the present invention is to solve such problems of the related art and to provide a piezoelectric polymer film including a piezoelectric layer that contains lead zirconate titanate particles in a matrix containing a polymer material and exhibiting more excellent piezoelectric characteristics.

In order to solve the above-described problem, the present invention has the following configurations.

[1] A piezoelectric polymer film comprising: a piezoelectric layer containing lead zirconate titanate particles in a matrix that contains a polymer material; and an electrode layer provided on each of both surfaces of the piezoelectric layer, in which a Raman shift of a maximum peak present in a range of 190 to 215 cm$^{-1}$ in a Raman spectrum of the piezoelectric layer is 205 cm$^{-1}$ or less; and in which in a case where a peak intensity of a maximum peak present in a range of 490 to 650 cm$^{-1}$ is defined as I550 and a peak intensity of a maximum peak present in a range of 700 to 750 cm$^{-1}$ is defined as I725 in the Raman spectrum of the piezoelectric layer, a peak intensity ratio I725/I550 is 0.25 or greater..

[2] The piezoelectric polymer film according to [1], further comprising: a protective layer covering the electrode layer.

[3] The piezoelectric polymer film according to [1] or [2], in which the lead zirconate titanate particles have an arithmetic average diameter of 1 to 10 μm.

[4] The piezoelectric polymer film according to any one of [1] to [3], in which in a case where a peak intensity of a maximum peak present in a range of 90 cm$^{-1}$ or greater and less than 120 cm$^{-1}$ is defined as I100 and a peak intensity of a maximum peak present in a range of 120 to 150 cm$^{-1}$ is defined as I130, in the Raman spectrum of the piezoelectric layer, a peak intensity ratio I130/I110 is 1.05 or greater.

[5] The piezoelectric polymer film according to any one of [1] to [4], in which the polymer material contains a cyanoethyl group.

[6] The piezoelectric polymer film according to [5], in which the polymer material is cyanoethylated polyvinyl alcohol.

[7] The piezoelectric polymer film according to any one of [1] to [6], in which the piezoelectric layer is polarized in a thickness direction.

According to the present invention, it is possible to provide a piezoelectric polymer film having excellent piezoelectric characteristics, which include a piezoelectric layer that contains lead zirconate titanate particles in a matrix containing a polymer material.

## BRIEF DESCRIPTION OF THE DRAWINGS

Fig. 1 is a view conceptually illustrating an example of a polymer film of the present invention.

Fig. 2 is a conceptual view for describing a method of preparing the piezoelectric film illustrated in Fig. 1.

Fig. 3 is a conceptual view for describing a method of preparing the piezoelectric film illustrated in Fig. 1.

Fig. 4 is a conceptual view for describing a method of preparing the piezoelectric film illustrated in Fig. 1.

Fig. 5 is a view conceptually illustrating an example of a piezoelectric speaker formed of the piezoelectric film illustrated in Fig. 1.

Fig. 6 is a conceptual view for describing a method of measuring a Raman spectrum in an example.

Fig. 7 is a conceptual view for describing a method of measuring a sound pressure of a piezoelectric speaker in an example.

## DESCRIPTION OF THE PREFERRED EMBODIMENTS

Hereinafter, a piezoelectric polymer film of the present invention will be described in detail based on preferred examples illustrated in the accompanying drawings.

Descriptions of the configuration requirements described below may be made based on representative embodiments of the present invention, but the present invention is not limited to such embodiments.

In the present specification, a numerical range shown using "to" indicates a range including numerical values described before and after "to" as a lower limit and an upper limit.

Further, all the drawings described below are conceptual views for describing the present invention. Therefore, the thickness of each layer, the size of the piezoelectric particles, the size of the constituent members, and the like are different from the actual values.

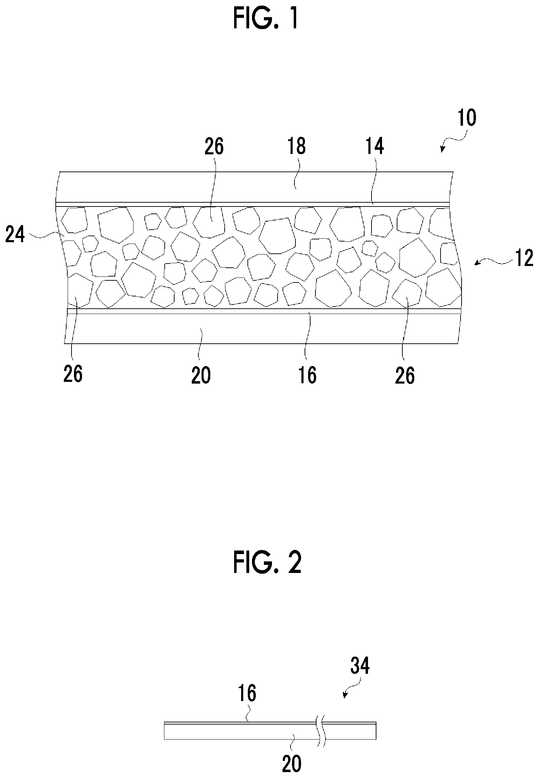

Fig. 1 conceptually illustrates an example of a piezoelectric polymer film according to the embodiment of the present invention.

As illustrated in Fig. 1, a piezoelectric polymer film 10 includes a piezoelectric layer 12, a first electrode layer 14 laminated on one surface of the piezoelectric layer 12, a first protective layer 18 laminated on the surface of the first electrode layer 14, a second electrode layer 16 laminated on the other surface of the piezoelectric layer 12, and a second protective layer 20 laminated on the surface of the second electrode layer 16. As will be described below, the piezoelectric layer 12 is polarized in a thickness direction.

In the following description, the piezoelectric polymer film 10 is also referred to as the piezoelectric film 10.

As a preferable aspect, the piezoelectric layer 12 of the piezoelectric film 10 contains lead zirconate titanate particles 26, which are piezoelectric particles, in a matrix 24 containing a polymer material, as conceptually illustrated in Fig. 1.

In the description below, lead zirconate titanate will also be referred to as PZT.

Here, as will be described in detail below, in the piezoelectric layer 12 of the piezoelectric film 10 according to the embodiment of the present invention, the Raman shift of the maximum peak present in a range of 190 to 215 cm$^{-1}$ in the Raman spectrum is 205 cm$^{-1}$ or less. With the above-described configuration, the piezoelectric film 10 according to the embodiment of the present invention exhibits excellent piezoelectric characteristics, and a high sound pressure can be obtained in a case where the piezoelectric film 10 is used, for example, as an electroacoustic conversion film.

As described above, the piezoelectric layer 12 of the piezoelectric film 10 according to the embodiment of the present invention is obtained by dispersing the PZT particles 26, which are piezoelectric particles, in the matrix 24 containing a polymer material. That is, the piezoelectric layer 12 is a polymer-based piezoelectric composite material.

Here, it is preferable that the polymer-based piezoelectric composite material (piezoelectric layer 12) satisfies the following requirements. Further, in the present invention, room temperature is in a range of 0°C to 50°C.

(i) Flexibility

For example, in a case of being gripped in a state of being loosely bent like a document such as a newspaper or a magazine as a portable device, the piezoelectric film is continuously subjected to large bending deformation from the outside at a relatively slow vibration of less than or equal to a few Hz. In this case, in a case where the polymer-based piezoelectric composite material is hard, a large bending stress is generated to that extent, and a crack is generated at the interface between a polymer matrix and piezoelectric particles, which may lead to breakage. Accordingly, the polymer-based piezoelectric composite material is required to have appropriate flexibility. In addition, in a case where strain energy is diffused into the outside as heat, the stress is able to be relieved. Therefore, the polymer-based piezoelectric composite material is required to have an appropriately large loss tangent.

(ii) Acoustic quality

In a speaker, the piezoelectric particles vibrate at a frequency of an audio band of 20 Hz to 20 kHz, and the vibration energy causes the entire vibration plate (polymer-based piezoelectric composite material) to vibrate integrally so that a sound is reproduced. Therefore, in order to increase the transmission efficiency of the vibration energy, the polymer-based piezoelectric composite material is required to have appropriate hardness. In addition, in a case where the frequencies of the speaker are smooth as the frequency characteristic thereof, an amount of change in acoustic quality in a case where the lowest resonance frequency $f_0$ is changed in association with a change in the curvature of the speaker decreases. Therefore, the loss tangent of the polymer-based piezoelectric composite material is required to be appropriately large.

It is known that the lowest resonance frequency $f_0$ of the vibration plate for a speaker is represented by the following equation. Here, s represents the stiffness of the vibration system and m represents the mass.

$$\text{Lowest resonance frequency}: f_0 = \frac{1}{2\pi}\sqrt{\frac{s}{m}}$$

Here, as the degree of curvature of the piezoelectric film, that is, the radius of curvature of the curved portion increases, the mechanical stiffness s decreases, and thus the lowest resonance frequency $f_0$ decreases. That is, the acoustic quality (the volume and the frequency characteristics) of the speaker changes depending on the radius of curvature of the piezoelectric film.

That is, the flexible polymer-based piezoelectric composite material used as an electroacoustic conversion film is required to exhibit a behavior of being rigid with respect to a vibration of 20 Hz to 20 kHz and being flexible with respect to a vibration of less than or equal to a few Hz. In addition, the loss tangent of a polymer-based piezoelectric composite material is required to be appropriately large with respect to the vibration of all frequencies of 20 kHz or less.

In general, a polymer solid has a viscoelasticity relieving mechanism, and a molecular movement having a large scale is observed as a decrease (relief) in a storage elastic modulus (Young's modulus) or a maximal value (absorption) in a loss elastic modulus along with an increase in temperature or a decrease in frequency. Among these, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

In the polymer-based piezoelectric composite material (piezoelectric layer 12), the polymer-based piezoelectric composite material exhibiting a behavior of being rigid with respect to a vibration of 20 Hz to 20 kHz and being flexible with respect to a slow vibration of less than or equal to a few Hz is realized by using a polymer material whose glass transition point is room temperature as a matrix. In particular, from the viewpoint that such a behavior is suitably exhibited, it is preferable that a polymer material in which the glass transition point at a frequency of 1 Hz is at room temperature, that is, in a range of 0°C to 50°C is used for a matrix of the polymer-based piezoelectric composite material.

Further, a polymer material whose glass transition point is room temperature is, that is, a polymer material having a viscoelasticity at room temperature.

Various known materials can be used as the polymer material having a viscoelasticity at room temperature. It is preferable to use a polymer material in which the maximal value of a loss tangent $\text{Tan}\delta$ at a frequency of 1 Hz according to a dynamic viscoelasticity test at room temperature, that is, in a temperature range of 0°C to 50°C is 0.5 or greater.

In this manner, in a case where the polymer-based piezoelectric composite material is slowly bent due to an external force, stress concentration on the interface between the polymer matrix and the piezoelectric particles at the maximum bending moment portion is relieved, and thus high flexibility can be expected.

In the polymer material having a viscoelasticity at room temperature, it is preferable that a storage elastic modulus (E') at a frequency of 1 Hz according to the dynamic viscoelasticity measurement is 100 MPa or greater at 0°C and 10 MPa or less at 50°C.

In this manner, the bending moment generated in a case where the polymer-based piezoelectric composite material is slowly bent due to the external force can be reduced, and the polymer-based piezoelectric composite material can exhibit a behavior of being rigid with respect to an acoustic vibration of 20 Hz to 20 kHz.

In addition, it is more suitable that the relative permittivity of the polymer material having a viscoelasticity at room temperature is 10 or greater at 25°C. Accordingly, in a case where a voltage is applied to the polymer-based piezoelectric composite material, a higher electric field is applied to the piezoelectric particles in the polymer matrix, and thus a large deformation amount can be expected.

However, in consideration of ensuring satisfactory moisture resistance and the like, it is suitable that the relative permittivity of the polymer material is 10 or less at 25°C.

Examples of the polymer material that satisfies such conditions and has a viscoelasticity at room temperature include cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, and polybutyl methacrylate. In addition, as these polymer materials, a commercially available product such as Hybrar 5127 (manufactured by Kuraray Co., Ltd.) can also be suitably used. Among these, it is preferable to use a material containing a cyanoethyl group and particularly preferable to use cyanoethylated PVA as the polymer material.

Further, these polymer materials in the matrix 24 may be used alone or in combination (mixture) of two or more kinds thereof.

In the matrix 24 formed of the polymer material having a viscoelasticity at room temperature, a plurality of polymer materials may be used in combination as necessary.

That is, for the purpose of adjusting dielectric characteristics, mechanical characteristics, and the like, other dielectric polymer materials may be added to the matrix 24 in addition to the polymer material having a viscoelasticity at room temperature such as cyanoethylated PVA as necessary.

Examples of the dielectric polymer material that can be added include a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, or a polyvinylidene fluoride-tetrafluoroethylene copolymer, a polymer containing a cyano group or a cyanoethyl group such as a vinylidene cyanide-vinyl acetate copolymer, cyanoethyl cellulose, cyanoethyl hydroxysaccharose, cyanoethyl hydroxycellulose, cyanoethyl hydroxypullulan, cyanoethyl methacrylate, cyanoethyl acrylate, cyanoethyl hydroxyethyl cellulose, cyanoethyl amylose, cyanoethyl hydroxypropyl cellulose, cyanoethyl dihydroxypropyl cellulose, cyanoethyl hydroxypropyl amylose, cyanoethyl polyacrylamide, cyanoethyl polyacrylate, cyanoethyl pullulan, cyanoethyl polyhydroxymethylene, cyanoethyl glycidol pullulan, cyanoethyl saccharose, or cyanoethyl sorbitol, and synthetic rubber such as nitrile rubber or chloroprene rubber.

Among these, a polymer material containing a cyanoethyl group is suitably used.

Further, in the matrix 24 of the piezoelectric layer 12, the number of kinds of the dielectric polymers to be added in addition to the material having a viscoelasticity at room temperature, such as cyanoethylated PVA, is not limited to one, and a plurality of kinds of the materials may be added.

In addition, for the purpose of adjusting the glass transition point Tg, a thermoplastic resin such as a vinyl chloride resin, polyethylene, polystyrene, a methacrylic resin, polybutene, or isobutylene, and a thermosetting resin such as a phenol resin, a urea resin, a melamine resin, an alkyd resin, or mica may be added to the matrix 24, in addition to the dielectric polymer materials.

Further, for the purpose of improving the pressure sensitive adhesiveness, a viscosity imparting agent such as rosin ester, rosin, terpene, terpene phenol, or a petroleum resin may be added.

In the matrix 24 of the piezoelectric layer 12, the addition amount in a case of adding materials other than the polymer material having a viscoelasticity at room temperature, such as cyanoethylated PVA, is not particularly limited, but is preferably set to 30% by mass or less in terms of the proportion of the materials in the matrix 24.

In this manner, the characteristics of the polymer material to be added can be exhibited without impairing the viscoelasticity relieving mechanism in the matrix 24, and thus preferable results, for example, an increase in the dielectric constant, improvement of the heat resistant, and improvement of the adhesiveness between the PZT particles 26 and the electrode layer can be obtained.

In the piezoelectric film 10 according to the embodiment of the present invention, the piezoelectric layer 12 contains the PZT particles 26 in such a matrix 24.

The PZT particles 26 are particles containing lead zirconate titanate (PZT) as a main component.

In the present invention, the term "main component" denotes a component that is contained in the largest amount in a substance, and the amount of the component is preferably 50% by mass or greater and more preferably 90% by mass or greater.

In the present invention, it is preferable that the PZT particles 26 contain only constituent elements of PZT, excluding unavoidable impurities that are unavoidably mixed.

As is well known, PZT is a solid solution of lead zirconate ($PbZrO_3$) and lead titanate ($PbTiO_3$) and is represented by General Formula $Pb(Zr_xTi_{1-x})O_3$. In the following description, General Formula $Pb(Zr_xTi_{1-x})O_3$ is also referred to as "General Formula [I]".

In General Formula [I], x is less than 1. Further, in General Formula [I], x represents an elemental ratio (molar ratio) between zirconium and titanium, that is, Zr/(Zr + Ti).

In the piezoelectric film 10 according to the embodiment of the present invention, x in General Formula [I] is not limited.

As described above, it is known that a ferroelectric having a perovskite structure such as PZT has a phase transition boundary (morphotropic phase boundary (MPB)) composition as the composition to obtain excellent piezoelectric characteristics. The MPB composition of PZT is a composition in which x in General Formula [I] represents a value close to 0.52. That is, in the MPB composition of PZT, General Formula [I] is approximately "$Pb(Zr_{0.52}Ti_{0.48})O_3$".

Therefore, it is preferable that x in General Formula [I] represents a value close to 0.52. Specifically, x in General Formula [I] represents preferably 0.50 to 0.54, more preferably 0.51 to 0.53, and still more preferably 0.52.

As described above, in the piezoelectric layer 12 of the piezoelectric film 10 according to the embodiment of the present invention, the Raman shift of the maximum peak present in a range of 190 to 215 $cm^{-1}$ in the Raman spectrum is 205 $cm^{-1}$ or less.

With the above-described configuration, the piezoelectric film 10 according to the embodiment of the present invention exhibits excellent piezoelectric characteristics, and a high sound pressure can be obtained in a case where the piezoelectric film 10 is used, for example, as an electroacoustic conversion film.

Here, the piezoelectric layer 12 is formed by dispersing PTZ particles 26 in the matrix 24 containing a polymer material. Therefore, the Raman spectrum of the piezoelectric layer 12 has peaks derived from the polymer material and peaks derived from PZT.

In the Raman spectrum, peaks in a range of 190 to 215 $cm^{-1}$ are peaks derived from PZT, and peaks derived from the polymer material do not occur in this wavenumber range.

That is, in the piezoelectric film 10 according to the embodiment of the present invention, the Raman shift of the maximum peak present in a range of 190 to 215 $cm^{-1}$ in the Raman spectrum of the PZT particles 26 constituting the piezoelectric layer 12 is 205 $cm^{-1}$ or less.

The present inventor of the present invention conducted intensive examination on the configuration capable of obtaining excellent piezoelectric characteristics for the piezoelectric film formed of a piezoelectric layer (polymer-based piezoelectric composite material) obtained by dispersing PZT particles in a matrix containing a polymer material.

As a result, it was found that the strain of crystal lattice of the PZT particles constituting the piezoelectric layer results in the degradation of the piezoelectric characteristics.

In a piezoelectric film in which electrode layers are provided on both surfaces of the polymer-based piezoelectric composite material obtained by dispersing the PZT particles in the matrix containing the polymer material, the PZT particles are stretched and contracted (expanded/contracted) by energizing the electrode layers and applying an electric field to the PZT particles. In a case where the piezoelectric film is used as an electroacoustic conversion film, a sound is output by stretching and contracting the PZT particles to stretch and contract the piezoelectric film and vibrating the piezoelectric film in a direction orthogonal to the surface thereof.

However, according to the examination of the present inventors, in a case where the crystal lattice of the PZT particles is strained, the responsiveness to a case of application of an electric field is degraded. As a result, the piezoelectric characteristics of the polymer-based piezoelectric composite material formed of PZT particles having a strain in the crystal lattice are degraded.

In the Raman spectrum of the PZT particles, peaks of crystal lattice vibration in an E(2TO) mode, which are derived from a lead-oxygen bonding state occur near 200 $cm^{-1}$.

However, in a case where the crystal lattice of the PZT particles is strained, peaks close to 200 $cm^{-1}$ move to a higher wavenumber side. The peaks move to the higher wavenumber side as the strain of the crystal lattice increases.

Meanwhile, in the piezoelectric film 10 according to the embodiment of the present invention, the Raman shift of the maximum peak present in a range of 190 to 215 $cm^{-1}$ in the Raman spectrum of the piezoelectric layer 12, that is, the PZT particles 26 in the piezoelectric film 10 formed of the piezoelectric layer 12 containing PZT particles 26 in the matrix 24 containing the polymer material is 205 $cm^{-1}$ or less.

That is, the piezoelectric film 10 according to the embodiment of the present invention can exhibit excellent piezoelectric characteristics by using the PZT particles 26 with an extremely small strain of the crystal lattice that causes degradation of the piezoelectric characteristics. Therefore, a sound with a high sound pressure can be output by using the piezoelectric film 10 according to the embodiment of the present invention as, for example, an electroacoustic conversion film.

In the piezoelectric film 10 according to the embodiment of the present invention, in a case where the Raman shift of the maximum peak present in a range of 190 to 215 cm$^{-1}$ in the Raman spectrum of the piezoelectric layer 12 is greater than 205 cm$^{-1}$, there are problems in that the strain of the crystal lattice of the PZT particles 26 increases, the piezoelectric characteristics cannot be sufficiently obtained, and a large sound pressure as a speaker vibration plate cannot be obtained in a case where the piezoelectric film is used as an electroacoustic conversion film or the like.

The Raman spectrum of the piezoelectric layer 12 has a maximum peak preferably in a range of 195 to 200 cm$^{-1}$ and more preferably in a range of 195 to 198 cm$^{-1}$, within a range of 190 to 215 cm$^{-1}$.

In the piezoelectric film 10 according to the embodiment of the present invention, in a case where the peak intensity of the maximum peak present in a range of 90 cm$^{-1}$ or greater and less than 120 cm$^{-1}$ is defined as I100 and the peak intensity of the maximum peak present in a range of 120 to 150 cm$^{-1}$ is defined as I130, in the Raman spectrum of the piezoelectric layer 12, a peak intensity ratio I130/I110 is preferably 1.05 or greater.

In the piezoelectric film 10 according to the embodiment of the present invention, in a case where the peak intensity of the maximum peak present in a range of 490 to 650 cm$^{-1}$ is defined as I550 and the peak intensity of the maximum peak present in a range of 700 to 750 cm$^{-1}$ is defined as I725 in the Raman spectrum of the piezoelectric layer 12, a peak intensity ratio I725/I550 is preferably 0.25 or greater.

In the Raman spectrum of the piezoelectric layer 12, that is, the PZT particles 26, deficiency of lead atoms leads to a dislocation of the crystal lattice and a decrease in peaks in the vicinity of 130 cm$^{-1}$ of crystal lattice vibration in an A (1TO) mode and peaks in the vicinity of 725 cm$^{-1}$ of crystal lattice vibration in an E (3LO) mode.

On the contrary, it is preferable that the piezoelectric film 10 according to the embodiment of the present invention satisfies optionally a condition that the peak intensity ratio I130/I110 is 1.05 or greater and satisfies a condition that the peak intensity ratio I725/I550 is 0.25 or greater in the Raman spectrum of the piezoelectric layer 12. It is more preferable that the piezoelectric film 10 according to the embodiment of the present invention satisfies both conditions of the peak intensity ratios.

In this manner, the piezoelectric film 10 according to the embodiment of the present invention can further suppress the strain of the crystal lattice and can obtain more satisfactory piezoelectric characteristics due to the PZT particles 26 in which lead atoms are less deficient.

The peak intensity ratio I130/I110 is more preferably 1.1 or greater and still more preferably 1.2 or greater.

In addition, the peak intensity ratio I725/I550 is more preferably 0.4 or greater and still more preferably 0.5 or greater.

Further, the upper limit of the peak intensity ratio I130/I110 is not limited, but is typically 1.3 or less. In addition, the upper limit of the peak intensity ratio I725/I550 is also not limited, but is typically 0.8 or less.

In the piezoelectric film 10 according to the embodiment of the present invention, the particle diameter of the PZT particles 26 is not limited, and may be appropriately selected according to the size of the piezoelectric film 10 and applications thereof.

The particle diameter of the PZT particles 26 is preferably in a range of 1 to 10 $\mu$m in terms of the arithmetic average diameter. In the following description, the particle diameter of the PZT particles 26 denotes the arithmetic average diameter of the PZT particles 26.

In the piezoelectric film 10 according to the embodiment of the present invention, the arithmetic average diameter of the PZT particles 26 is measured as follows.

First, the piezoelectric film 10 is cut in the thickness direction at an optional position. In other words, the thickness direction is the lamination direction of the piezoelectric layer 12, the first electrode layer 14, the first protective layer 18, the second electrode layer 16, and the second protective layer 20 in the piezoelectric film 10, which is the vertical direction of Fig. 1.

A cross section of the piezoelectric film 10 in the thickness direction is observed with a scanning electron microscope, including the upper end and the lower end of the piezoelectric layer 12 in the field of view, and the area ratio of the PZT particles 26 in the piezoelectric layer 12 is calculated by image-analyzing the microscopic image. The area ratio of the PZT particles 26 is divided by the number of PZT particles 26 in the microscopic image, and the particle diameter of the PZT particles 26 is calculated by converting the area into circles. The calculation of the particle diameter of the PZT particles 26 is performed on optionally selected five cross sections in the piezoelectric film 10, and the average value of the particle diameters of the five cross sections is defined as the particle diameter (arithmetic average diameter) of the PZT particles 26 in the piezoelectric film 10.

It is preferable that the particle diameter of the PZT particles 26 is set to 1 $\mu$m or greater from the viewpoint of obtaining transmission efficiency of high vibration energy.

It is preferable that the particle diameter of the PZT particles 26 is set to 10 $\mu$m or less from the viewpoint of stably obtaining desired output characteristics regardless of the bending state in a case where the piezoelectric film is used as an electroacoustic conversion film or the like capable of obtaining satisfactory piezoelectric characteristics by reducing the PZT particles 26 that contribute to the roughness of the surface facing the electrode layer described below.

The particle diameter of the PZT particles 26 is more preferably in a range of 1.5 to 7 $\mu$m and more preferably in a range of 2 to 5 $\mu$m.

The PZT particles 26 in the piezoelectric layer 12 are irregularly dispersed in the matrix 24 in Fig. 1, but the present invention is not limited thereto.

That is, the piezoelectric particles 26 in the piezoelectric layer 12 may be regularly dispersed in the matrix 24 as long as the piezoelectric particles 26 are preferably uniformly dispersed therein.

Further, the particle diameter of the PZT particles 26 may or may not be uniform.

In the piezoelectric film 10, the ratio between the amount of the matrix 24 and the amount of the PZT particles 26 in the piezoelectric layer 12 is not limited and may be appropriately set according to the size and the thickness of the piezoelectric film 10 in the plane direction, the applications of the piezoelectric film 10, the characteristics required for the piezoelectric film 10, and the like.

The volume fraction of the PZT particles 26 in the piezoelectric layer 12 is preferably in a range of 30% to 80%, more preferably 50% or greater, and still more preferably in a range of 50% to 80%.

By setting the ratio between the amount of the matrix 24 and the amount of the piezoelectric particles 26 to be in the above-described range, preferable results in terms of achieving both of excellent piezoelectric characteristics and flexibility can be obtained.

Further, the thickness of the piezoelectric layer 12 in the piezoelectric film 10 is not particularly limited and may be appropriately set according to the applications of the piezoelectric film 10, the characteristics required for the piezoelectric film 10, and the like.

It is advantageous that the thickness of the piezoelectric layer 12 increases in terms of the rigidity such as the strength of stiffness of a so-called sheet-like material, but the voltage (potential difference) required to stretch and contract the piezoelectric film 10 by the same amount increases.

The thickness of the piezoelectric layer 12 is preferably in a range of 8 to 300 $\mu$m, more preferably in a range of 8 to 200 $\mu$m, still more preferably in a range of 10 to 150 $\mu$m, and particularly preferably in a range of 15 to 100 $\mu$m.

By setting the thickness of the piezoelectric layer 12 to be in the above-described range, preferable results in terms of achieving both ensuring of the rigidity and moderate elasticity can be obtained.

It is preferable that the piezoelectric layer 12 is subjected to a polarization treatment (poling) in the thickness direction. The polarization treatment will be described in detail later.

As illustrated in Fig. 1, the piezoelectric film 10 of the illustrated example has a configuration in which the first electrode layer 14 is provided on one surface of the piezoelectric layer 12, the first protective layer 18 is provided on the surface thereof, the second electrode layer 16 is provided on the other surface of the piezoelectric layer 12, and the second protective layer 20 is provided on the surface thereof. In the piezoelectric film 10, the first electrode layer 14 and the second electrode layer 16 form an electrode pair.

That is, the piezoelectric film 10 has a configuration in which both surfaces of the piezoelectric layer 12 are sandwiched between a pair of electrodes, that is, the first electrode layer 14 and the second electrode layer 16 and this laminate is sandwiched between the first protective layer 18 and the second protective layer 20.

In such a piezoelectric film 10, the region sandwiched between the first electrode layer 14 and the second electrode layer 16 stretches and contracts according to the applied voltage.

In the present invention, the terms "first" and "second" in the first electrode layer 14 and the first protective layer 18, and the second electrode layer 16 and the second protective layer 20 are provided based on the accompanying drawings for convenience in order to describe the piezoelectric film 10. Therefore, the terms "first" and "second" in the piezoelectric film 10 have no technical meaning and are irrelevant to the actual use state.

The first protective layer 18 and the second protective layer 20 in the piezoelectric film 10 have a function of coating the first electrode layer 14 and the second electrode layer 16 and applying moderate rigidity and mechanical strength to the piezoelectric layer 12. That is, the piezoelectric layer 12 consisting of the matrix 24 and the PZT particles 26 in the piezoelectric film 10 exhibits extremely excellent flexibility under bending deformation at a slow vibration, but may have insufficient rigidity or mechanical strength depending on the applications. As a compensation for this, the piezoelectric film 10 is provided with the first protective layer 18 and the second protective layer 20.

In the piezoelectric film 10 of the illustrated example, the first protective layer 18 and the second protective layer 20 are provided to sandwich the laminate of the piezoelectric layer 12 and the electrode layers so as to correspond to both the first electrode layer 14 and the second electrode layer 16 as a preferable aspect.

In the piezoelectric film 10 according to the embodiment of the present invention, the first protective layer 18 and the second protective layer 20 are provided as a preferable aspect. Therefore, the piezoelectric film according to the embodiment of the present invention may have neither the first protective layer 18 nor the second protective layer 20 or may have only one of the first protective layer 18 or the second protective layer 20.

However, in consideration of the mechanical strength, the rigidity, the durability, and the like of the piezoelectric film in the present invention, it is preferable that the first protective layer 18 and the second protective layer 20 are provided to sandwich the laminate of the piezoelectric layer 12 and the electrode layers as the example of the piezoelectric film 10 illustrated in the figure.

The first protective layer 18 and the second protective layer 20 are not limited, and various sheet-like materials can be used as the protective layer, and suitable examples thereof include various resin films.

Among these, from the viewpoints of excellent mechanical characteristics and heat resistance, a resin film consisting of polyethylene terephthalate (PET), polypropylene (PP), polystyrene (PS), polycarbonate (PC), polyphenylene sulfide (PPS), polymethylmethacrylate (PMMA), polyetherimide (PEI), polyimide (PI), polyethylene naphthalate (PEN), triacetyl cellulose (TAC), and a cyclic olefin-based resin is suitably used.

The thickness of each of the first protective layer 18 and the second protective layer 20 is also not limited. In addition, the thicknesses of the first protective layer 18 and the second protective layer 20 are basically the same as each other, but may be different from each other.

Here, in a case where the rigidity of the first protective layer 18 and the second protective layer 20 is extremely high, not only is the stretch and contraction of the piezoelectric layer 12 constrained, but also the flexibility is impaired. Therefore, it is advantageous that the thickness of the first protective layer 18 and the second protective layer 20 decrease except for the case where the mechanical strength or excellent handleability as a sheet-like material is required.

In a case where the thickness of the first protective layer 18 and the second protective layer 20 in the piezoelectric film 10 is two times or less the thickness of the piezoelectric layer 12, preferable results in terms of achieving both ensuring of the rigidity and moderate elasticity can be obtained.

For example, in a case where the thickness of the piezoelectric layer 12 is 50 $\mu$m and the first protective layer 18 and the second protective layer 20 consist of PET, the thickness of the first protective layer 18 and the second protective layer 20 is preferably 100 $\mu$m or less, more preferably 50 $\mu$m or less, and still more preferably 25 $\mu$m or less.

In the piezoelectric film 10, the first electrode layer 14 is formed between the piezoelectric layer 12 and the first protective layer 18, and the second electrode layer 16 is formed between the piezoelectric layer 12 and the second protective layer 20. In the description below, the first electrode layer 14 is also referred to as the first electrode layer 14 and the second electrode layer 16 is also referred to as the second electrode layer 16.

The first electrode layer 14 and the second electrode layer 16 are provided to apply a voltage to the piezoelectric layer 12 (piezoelectric film 10).

In the present invention, the material for forming the first electrode layer 14 and the second electrode layer 16 is not limited, and various conductors can be used as the material. Specific examples thereof include metals such as carbon, palladium, iron, tin, aluminum, nickel, platinum, gold, silver, copper, titanium, chromium, and molybdenum, alloys thereof, laminates and composite bodies of these metals and alloys, and indium tin oxide. Among these, copper, aluminum, gold, silver, platinum, and indium tin oxide are suitably exemplified as the material of the first electrode layer 14 and the second electrode layer 16.

In addition, the method of forming the first electrode layer 14 and the second electrode layer 16 is not limited, and various known methods, for example, a film forming method such as a vapor-phase deposition method (a vacuum film forming method) such as vacuum vapor deposition or sputtering, a film forming method of using plating, and a method of bonding a foil formed of the materials described above can be used.

Among these, particularly from the viewpoint of ensuring the flexibility of the piezoelectric film 10, a thin film made of copper, aluminum, or the like formed by vacuum vapor deposition is suitably used as the first electrode layer 14 and the second electrode layer 16. Among these, particularly a thin film made of copper formed by vacuum vapor deposition is suitably used.

The thicknesses of the first electrode layer 14 and the second electrode layer 16 are not limited. In addition, the thicknesses of the first electrode layer 14 and the second electrode layer 16 are basically the same as each other, but may be different from each other.

Here, similarly to the first protective layer 18 and the second protective layer 20 described above, in a case where the rigidity of the first electrode layer 14 and the second electrode layer 16 is extremely high, not only is the stretch and contraction of the piezoelectric layer 12 constrained, but also the flexibility is impaired. Therefore, it is advantageous that the thickness of the first electrode layer 14 and the second electrode layer 16 decreases in a case where the electrical resistance is not excessively high.

It is suitable that the product of the thickness and the Young's modulus of the first electrode layer 14 and the second electrode layer 16 of the piezoelectric film 10 is less than the product of the thickness and the Young's modulus of the first protective layer 18 and the second protective layer 20 from the viewpoint that the flexibility is not considerably impaired.

A combination of the first protective layer 18 and the second protective layer 20 which are formed of PET and a combination of the first electrode layer 14 and the second electrode layer 16 which are formed of copper may be considered as an example. In this combination, PET has a Young's modulus of approximately 6.2 GPa and copper has a Young's modulus of approximately 130 GPa. Therefore, in this case, in a case where the thickness of the first protective layer 18 and the second protective layer 20 is set to 25 $\mu$m, the thickness of the first electrode layer 14 and the second electrode layer 16 is preferably 1.2 $\mu$m or less, more preferably 0.3 $\mu$m or less, and still more preferably 0.1 $\mu$m or less.

As described above, the piezoelectric film 10 has a configuration in which the piezoelectric layer 12 containing the PZT particles 26 in the matrix 24 containing the polymer material that has a viscoelasticity at room temperature is sandwiched between the first electrode layer 14 and the second electrode layer 16 and this laminate is sandwiched between the first protective layer 18 and the second protective layer 20.

It is preferable that, in such a piezoelectric film 10, the maximal value of the loss tangent (tan$\delta$) at a frequency of 1 Hz according to dynamic viscoelasticity measurement is present at room temperature and more preferable that the maximal value at which the loss tangent is 0.1 or greater is present at room temperature.

In this manner, even in a case where the piezoelectric film 10 is subjected to bending deformation at a slow vibration of less than or equal to a few Hz from the outside, since the strain energy can be effectively diffused to the outside as heat, occurrence of cracks on the interface between the polymer matrix and the piezoelectric particles can be prevented.

In the piezoelectric film 10, it is preferable that the storage elastic modulus (E') at a frequency of 1 Hz according to the dynamic viscoelasticity measurement is 10 to 30 GPa at 0°C and 1 to 10 GPa at 50°C.

In this manner, the piezoelectric film 10 may have large frequency dispersion in the storage elastic modulus (E') at room temperature. That is, the piezoelectric film 10 can exhibit a behavior of being rigid with respect to a vibration of 20 Hz to 20 kHz and being flexible with respect to a vibration of less than or equal to a few Hz.

In the piezoelectric film 10, it is preferable that the product of the thickness and the storage elastic modulus (E') at a frequency of 1 Hz according to the dynamic viscoelasticity measurement is in a range of $1.0 \times 10^6$ to $2.0 \times 10^6$ N/m at 0°C and in a range of $1.0 \times 10^5$ to $1.0 \times 10^6$ N/m at 50°C.

In this manner, the piezoelectric film 10 may have appropriate rigidity and mechanical strength within a range not impairing the flexibility and the acoustic characteristics.

Further, in the piezoelectric film 10, it is preferable that the loss tangent (Tan$\delta$) at a frequency of 1 kHz at 25°C is 0.05 or greater in a master curve obtained from the dynamic viscoelasticity measurement.

In this manner, the frequency of a speaker formed of the piezoelectric film 10 is smooth as the frequency characteristic thereof, and thus an amount of a change in acoustic quality in a case where the lowest resonance frequency $f_0$ is changed according to a change in the curvature of the speaker can be decreased.

Further, the piezoelectric film 10 may further include a bonding layer for bonding the electrode layer and the piezoelectric layer 12 to each other and a bonding layer for bonding the electrode layer and the protective layer to each other, in addition to the electrode layers and the protective layers.

The bonding agent may be an adhesive or a pressure sensitive adhesive. Further, the same material as the polymer material obtained by removing the PZT particles 26 from the piezoelectric layer 12, that is, the matrix 24 can also be suitably used as the bonding agent. Further, the bonding layer may be provided on both the first electrode layer 14 side and the second electrode layer 16 side or may be provided only on one of the first electrode layer 14 side or the second electrode layer 16 side.

Further, the piezoelectric film 10 may further include an electrode lead-out portion that leads out the electrodes from the first electrode layer 14 and the second electrode layer 16, and an insulating layer which covers a region where the piezoelectric layer 12 is exposed for preventing a short circuit or the like, in addition to the above-described layers.

The electrode lead-out portion may be configured such that a portion where the electrode layer and the protective layer project convexly outside the piezoelectric layer 12 in the plane direction is provided and the protruding portion may be used as the electrode lead-out portion. Alternatively, the electrode lead-out portion may be configured such that a part of the protective layer is removed to form a hole portion, and a conductive material such as silver paste is inserted into the hole portion so that the conductive material is electrically conducted with the electrode layer.

Further, the number of electrode lead-out portions is not limited to one, and each electrode layer may have two or more electrode lead-out portions. Particularly in a case of the configuration in which the electrode lead-out portion is obtained by removing a part of the protective layer and inserting a conductive material into the hole portion, it is preferable that the piezoelectric film has three or more electrode lead-out portions in order to more reliably ensure the conduction.

Next, an example of the method of producing the piezoelectric film 10 illustrated in Fig. 1 will be described with reference to the conceptual views of Figs. 2 to 4.

First, as illustrated in Fig. 2, a sheet-like material 34 in which the first electrode layer 14 is formed on the protective layer 18 is prepared. The sheet-like material 34 may be prepared by forming a copper thin film or the like as the first electrode layer 14 on the surface of the first protective layer 18 using vacuum vapor deposition, sputtering, plating, or the like.

In a case where the first protective layer 18 is extremely thin and thus the handleability is degraded, the first protective layer 18 with a separator (temporary support) may be used as necessary. Further, a PET having a thickness of 25 $\mu$m to 100 $\mu$m or the like can be used as the separator. The separator may be removed after thermal compression bonding of the second electrode layer 16 and the second protective layer 20 and before lamination of any member on the first protective layer 18.

Meanwhile, PZT particles 26 are prepared.

The method of preparing the PZT particles 26 may be basically the same as that for typical PZT particles.

First, raw material mixed powder is prepared by mixing lead oxide powder, zirconium oxide powder, and titanium oxide powder according to the desired composition of PZT. The composition of PZT in the PZT particles 26 substantially matches the composition of the raw material mixed powder (preparation composition).

Next, the raw material mixed powder is fired at approximately 700°C to 800°C for 1 to 5 hours to prepare raw material particles of PZT.

Next, the raw material particles obtained by firing the raw material mixed powder are pulverized by a ball mill to obtain PZT particles 26 having a desired particle diameter.

Here, according to the examination of the present inventors, the strain and deficiency that cause degradation of the piezoelectric characteristics occur in the crystal lattice of the PZT particles during the pulverization with a ball mill. That is, in order to obtain PZT particles in which the strain and deficiency of the crystal lattice are suppressed, the conditions for pulverization with a ball mill are required to be appropriately set.

Specifically, pulverization with a ball mill is controlled by the media diameter, the filling rate, the rotation speed, the pulverization time, and the like. The pulverization is promoted by collision of balls, and the strain, deficiency, and the like of the crystal lattice occur concurrently. In particular, the collision between the powder with low internal deficiency and the media at the latter stage of pulverization is considered to lead to the strain of the crystal lattice.

A decrease in the media diameter and a decrease in the rotation speed are effective in suppressing strain and deficiency of the crystal lattice. Meanwhile, in a case where the media diameter is extremely small or the rotation speed is low in the pulverization with a ball mill, the energy required for pulverization cannot be obtained, and the PZT particles 26 having a desired particle diameter cannot be obtained.

Further, in the PZT particles 26, deficiency of atoms such as lead atoms is easily affected by shearing with the media. A decrease in the filling rate of the media is effective in suppressing deficiency of atoms such as lead atoms.

From the above-described viewpoints, both suppression of strain and deficiency of the crystal lattice of the PZT particles 26 and reduction of the particle diameter of the PZT particles 26 contributing the roughness of the surface facing the electrode layer of the piezoelectric layer 12 are achieved by appropriately adjusting the media diameter, the filling rate, the rotation speed, and the pulverization time in the pulverization with a ball mill, thereby obtaining the piezoelectric layer 12 having satisfactory piezoelectric characteristics.

In the pulverization of the PZT sintered body with a ball mill, the media diameter (ball diameter) is preferably in a range of 0.1 to 5 mm, more preferably in a range of 0.4 to 1.5 mm, and even still more preferably in a range of 0.8 to 1.2 mm.

In the pulverization of the PZT sintered body with a ball mill, the filling rate is preferably in a range of 15% to 60%, more preferably in a range of 20% to 50%, and still more preferably in a range of 25% to 35%.

In the pulverization of the PZT sintered body with a ball mill, the rotation speed is preferably in a range of 20 to 80 rpm (revolutions per minute), more preferably in a range of 30 to 70 rpm, and still more preferably in a range of 40 to 60 rpm.

Further, in the pulverization of the PZT sintered body with the ball mill, the pulverization time may be appropriately set according to the media diameter, the filling rate, and the rotation speed. The pulverization time is, for example, preferably in a range of 8 to 24 hours (hr), more preferably in a range of 10 to 20 hr, and still more preferably in a range of 12 to 15 hr.

In the pulverization of the PZT sintered body with a ball mill, the strain and deficiency of the crystal lattice are suppressed and the particle diameter of the PZT particles 26 is suitably controlled by appropriately adjusting the media diameter, the filling rate, the rotation speed, and the pulverization time as described above, thereby preparing suitable PZT particles 26 in which the strain and deficiency of the crystal lattice are suppressed and the particles contributing to the roughness of the surface facing the electrode layer of the piezoelectric layer 12 are reduced.

That is, the piezoelectric layer, that is, the PZT particles 26 satisfying the conditions that a desired particle diameter, for example, the particle diameter is in a range of 1 to 10 $\mu$m, the Raman shift of the maximum peak present in a range of 190 to 215 cm$^{-1}$ in the Raman spectrum is 205 cm$^{-1}$ or less, and preferably, the above-described peak intensity ratio I130/I110 is 1.05 or greater and the peak intensity ratio I725/I550 is 0.25 or greater can be obtained by appropriately adjusting the media diameter, the filling rate, the rotation speed, and the pulverization time as described above.

As a result, for example, an electroacoustic conversion film that stably exhibits excellent output characteristics can be realized regardless of the bending state by using the piezoelectric film 10 according to the embodiment of the present invention as an electroacoustic conversion film.

Further, the pulverization of the PZT sintered body with a ball mill may be of a wet type or a dry type, but is preferably a wet type. In a case of wet type pulverization, the liquid (solvent) used for pulverization is not limited, but examples include acetone, methyl ethyl ketone (MEK), ethanol, isopropyl alcohol, ether, cyclohexane, toluene, and water.

After the preparation of the PZT particles in the above-described manner, a coating material is prepared by dissolving a polymer material having a viscoelasticity at room temperature, such as cyanoethylated PVA, in an organic solvent, adding the PZT particles 26 thereto, and stirring and dispersing the mixture. In the following description, the polymer material having a viscoelasticity at room temperature, such as cyanoethylated PVA, will also be referred to as "viscoelastic material".

The organic solvent is not limited, and various organic solvents such as dimethylformamide (DMF), methyl ethyl ketone, and cyclohexanone can be used.

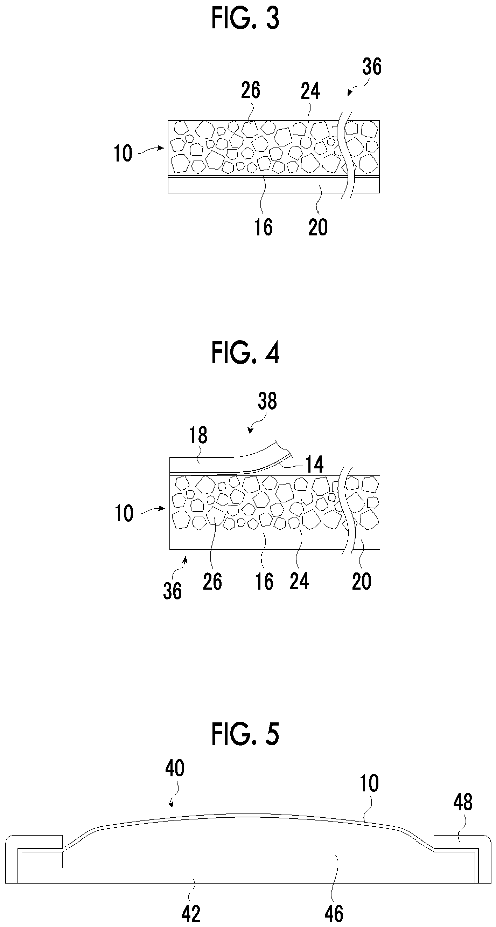

In a case where the sheet-like material 34 is prepared and the coating material is prepared, the coating material is cast (applied) onto the sheet-like material 34, and the organic solvent is evaporated and dried. In this manner, as illustrated in Fig. 3, a laminate 36 in which the first electrode layer 14 is provided on the first protective layer 18 and the piezoelectric layer 12 is formed on the first electrode layer 14 is prepared. Further, as described above, the first electrode layer 14 denotes an electrode on the base material side in a case of coating the piezoelectric layer 12, and does not denote the vertical positional relationship in the laminate.

A casting method for the coating material is not limited, and all known coating methods (coating devices) such as a slide coater and a doctor knife can be used.

Further, in a case where the viscoelastic material is a material that can be heated and melted, such as cyanoethylated PVA, the laminate 36 in which the first electrode layer 14 is provided on the first protective layer 18 and the piezoelectric layer 12 is formed on the first electrode layer 14 as illustrated in Fig. 3 may be prepared by heating and melting the viscoelastic material to prepare a melt obtained by adding the PZT particles 26 to the melt to be dispersed therein, extruding the melt on the sheet-like material 34 illustrated in Fig. 2 in a sheet shape by carrying out extrusion molding or the like, and cooling the laminate.

As described above, in the piezoelectric film 10, in addition to the viscoelastic material such as cyanoethylated PVA, a dielectric polymer material such as polyvinylidene fluoride may be added to the matrix 24.

In a case where the polymer piezoelectric material is added to the matrix 24, the polymer piezoelectric material to be added to the coating material may be dissolved. Alternatively, the polymer piezoelectric material to be added may be added to the above-described viscoelastic material heated and melted so that the mixture is heated and melted.

Further, after preparation of the laminate 36 in which the first electrode layer 14 is provided on the first protective layer 18 and the piezoelectric layer 12 is formed on the first electrode layer 14, the piezoelectric layer 12 is subjected to a polarization treatment (poling).

The method of performing a polarization treatment on the piezoelectric layer 12 is not limited, and a known method can be used. For example, electric field poling in which a direct current electric field is directly applied to a target to be subjected to the polarization treatment is exemplified. Further, in a case of performing electric field poling, the electric field poling treatment may be performed using the first electrode layer 14 and the second electrode layer 16 by forming the first electrode layer 14 before the polarization treatment.

Further, in a case where the piezoelectric film 10 according to the embodiment of the present invention is produced, it is preferable that the polarization treatment is performed on the piezoelectric layer 12 in the thickness direction instead of the plane direction.

Before the polarization treatment, a calender treatment may be performed to smoothen the surface of the piezoelectric layer 12 using a heating roller or the like. By performing the calender treatment, a thermal compression bonding step described below can be smoothly performed.

In this manner, while the piezoelectric layer 12 of the laminate 36 is subjected to the polarization treatment as described above, a sheet-like material 38 in which the second electrode layer 16 is formed on the second protective layer 20 is prepared. The sheet-like material 38 may be prepared by forming a copper thin film or the like as the second electrode layer 16 on the surface of the second protective layer 20 using vacuum vapor deposition, sputtering, plating, or the like.

Next, as illustrated in Fig. 4, the sheet-like material 38 is laminated on the laminate 36 in which the polarization treatment performed on the piezoelectric layer 12 is completed in a state where the second electrode layer 16 is directed toward the piezoelectric layer 12.

Further, a laminate of the laminate 36 and the sheet-like material 38 is subjected to the thermal compression bonding using a heating press device, a pair of heating rollers, or the like such that the second protective layer 20 and the first protective layer 18 are sandwiched between the laminate 36 and the sheet-like material 38, thereby preparing the piezoelectric film 10.

Alternatively, the piezoelectric film 10 may be prepared by bonding and preferably further compression-bonding the laminate 36 and the sheet-like material 38 to each other using an adhesive.

The piezoelectric film 10 to be prepared in the above-described manner is polarized in the thickness direction instead of the plane direction, and thus excellent piezoelectric characteristics are obtained even in a case where the stretching treatment is not performed after the polarization treatment. Therefore, the piezoelectric film 10 has no in-plane anisotropy as a piezoelectric characteristic, and stretches and contracts isotropically in all directions in the in-plane direction in a case where a driving voltage is applied.

Further, the piezoelectric film 10 may be produced using the cut sheet-like material 34 and the cut sheet-like material 38 or may be produced using roll-to-roll (Roll to Roll).

Fig. 5 conceptually illustrates an example of a flat plate type piezoelectric speaker formed of the piezoelectric film 10 according to the embodiment of the present invention.

The piezoelectric speaker 40 is a flat plate type piezoelectric speaker formed of the piezoelectric film 10 as a vibration plate that converts an electrical signal into vibration energy. Further, the piezoelectric speaker 40 can also be used as a microphone, a sensor, or the like. Further, the piezoelectric speaker can also be used as a vibration sensor.

The piezoelectric speaker 40 is configured to have the piezoelectric film 10, a case 42, a viscoelastic support 46, and a frame 48.

The case 42 is a thin housing formed of plastic or the like and having one surface that is open. Examples of the shape of the housing include a rectangular parallelepiped shape, a cubic shape, and a cylindrical shape.

Further, the frame 48 is a frame material that has, in the center thereof, a through hole having the same shape as the opening surface of the case 42 and engages with the opening surface side of the case 42.

The viscoelastic support 46 is a support used for efficiently converting the stretch and contraction movement of the piezoelectric film 10 into a forward and rearward movement by means of having appropriate viscosity and elasticity, supporting the piezoelectric film 10, and applying a constant mechanical bias to any place of the piezoelectric film. Further, the forward and rearward movement of the piezoelectric film 10 denotes a movement in a direction perpendicular to the surface of the film.

Examples of the viscoelastic support 46 include nonwoven fabric such as wool felt or wood felt containing PET and glass wool.

The piezoelectric speaker 40 is configured by accommodating the viscoelastic support 46 in the case 42, covering the case 42 and the viscoelastic support 46 with the piezoelectric film 10, and fixing the frame 48 to the case 42 in a state of pressing the periphery of the piezoelectric film 10 against the upper end surface of the case 42 by the frame 48.

Here, in the piezoelectric speaker 40, the viscoelastic support 46 has a shape in which the height (thickness) is larger than the height of the inner surface of the case 42.

Therefore, in the piezoelectric speaker 40, the viscoelastic support 46 is held in a state of being thinned by being pressed downward by the piezoelectric film 10 at the peripheral portion of the viscoelastic support 46. Similarly, in the peripheral portion of the viscoelastic support 46, the curvature of the piezoelectric film 10 suddenly fluctuates, and a rising portion that decreases in height toward the periphery of the viscoelastic support 46 is formed in the piezoelectric film 10. Further, the central region of the piezoelectric film 10 is pressed by the viscoelastic support 46 having a square columnar shape and has a (approximately) planar shape.

In the piezoelectric speaker 40, in a case where the piezoelectric film 10 is stretched in the plane direction due to the application of a driving voltage to the first electrode layer 14 and the second electrode layer 16, the rising portion of the piezoelectric film 10 changes the angle in a rising direction due to the action of the viscoelastic support 46 in order to absorb the stretched part. As a result, the piezoelectric film 10 having the planar portion moves upward.

On the contrary, in a case where the piezoelectric film 10 is contracted in the plane direction due to the application of the driving voltage to the second electrode layer 16 and the first electrode layer 14, the rising portion of the piezoelectric film 10 changes the angle in a falling direction (a direction approaching the flat surface) in order to absorb the contracted part. As a result, the piezoelectric film 10 having the planar portion moves downward.

The piezoelectric speaker 40 generates a sound by the vibration of the piezoelectric film 10.

In the piezoelectric film 10 according to the embodiment of the present invention, the conversion from the stretching and contracting movement to vibration can also be achieved by holding the piezoelectric film 10 in a curved state.

Therefore, the piezoelectric film 10 according to the embodiment of the present invention can function as a piezoelectric speaker having flexibility, a vibration sensor, or the like by being simply maintained in a curved state instead of the flat plate-like piezoelectric speaker 40 having rigidity as illustrated in Fig. 5.

The piezoelectric speaker formed of the piezoelectric film 10 can be stored in a bag or the like by, for example, being rolled or folded using satisfactory flexibility. Therefore, with the piezoelectric film 10, a piezoelectric speaker that can be easily carried even in a case where the piezoelectric speaker has a certain size can be realized.

Further, as described above, the piezoelectric film 10 has excellent softness and excellent flexibility, and has no in-plane anisotropy as a piezoelectric characteristic. Therefore, in the piezoelectric film 10, a change in acoustic quality regardless of the direction in which the film is bent is small, and a change in acoustic quality with respect to the change in curvature is also small. Accordingly, the piezoelectric speaker formed of the piezoelectric film 10 has a high degree of freedom of the installation place and can be attached to various products as described above. For example, a so-called wearable speaker can be realized by attaching the piezoelectric film 10 to clothing such as a suit and portable items such as a bag in a curved state.

Further, as described above, the piezoelectric film according to the embodiment of the present invention can be used for a speaker of a display device by bonding the piezoelectric film to a display device having flexibility such as an organic EL display device having flexibility or a liquid crystal display device having flexibility.

As described above, the piezoelectric film 10 stretches and contracts in the plane direction in a case where a voltage is applied, and vibrates suitably in the thickness direction due to the stretch and contraction in the plane direction, and thus a satisfactory acoustic characteristic of outputting a sound with a high sound pressure is exhibited in a case where the piezoelectric film 10 is used for a piezoelectric speaker or the like.

The piezoelectric film 10, which exhibits excellent acoustic characteristics, that is, high stretch and contraction performance due to piezoelectricity is satisfactorily operated as a piezoelectric vibrating element that vibrates a vibration body such as a vibration plate by laminating a plurality of the piezoelectric films. Since the piezoelectric film 10 has a satisfactory heat dissipation property, heat generation of the vibration plate can be prevented even in a case of being laminated and formed into a piezoelectric vibrating element, and thus heating of the vibration plate can be prevented.

Further, in a case of lamination of the piezoelectric films 10, each piezoelectric film may not have the first protective layer 18 and/or the second protective layer 20 unless there is a possibility of a short circuit. Alternatively, the piezoelectric films that do not have the first protective layer 18 and/or the second protective layer 20 may be laminated through an insulating layer.

As an example, a speaker in which a laminate of the piezoelectric films 10 is bonded to the vibration plate and the vibration plate is vibrated by the laminate of the piezoelectric films 10 to output a sound may be used. That is, in this case, the laminate of the piezoelectric film 10 acts as a so-called exciter that outputs a sound by vibrating the vibration plate.

By applying a driving voltage to the laminated piezoelectric films 10, each piezoelectric film 10 stretches and contracts in the plane direction, and the entire laminate of the piezoelectric film 10 stretches and contracts in the plane direction due to the stretch and contraction of each piezoelectric film 10. The vibration plate to which the laminate has been attached is bent due to the stretch and contraction of the laminate of the piezoelectric film 10 in the plane direction, and thus the vibration plate vibrates in the thickness direction. The vibration plate generates a sound using the vibration in the thickness direction. The vibration plate vibrates according to the magnitude of the driving voltage applied to the piezoelectric film 10 and generates a sound according to the driving voltage applied to the piezoelectric film 10.

Therefore, the piezoelectric film 10 itself does not output sound in this case.

Therefore, even in a case where the rigidity of each piezoelectric film 10 is low and the stretching and contracting force thereof is small, the rigidity is increased by laminating the piezoelectric films 10, and the stretching and contracting force as the entire laminate is increased. As a result, in the laminate of the piezoelectric films 10, even in a case where the vibration plate has a certain degree of rigidity, the vibration plate is sufficiently bent with a large force and the vibration plate can be sufficiently vibrated in the thickness direction, whereby the vibration plate can generate a sound.

In the laminate of the piezoelectric film 10, the number of laminated piezoelectric films 10 is not limited, and the number of sheets set such that a sufficient amount of vibration is obtained may be appropriately set according to, for example, the rigidity of the vibration plate to be vibrated.

Further, one piezoelectric film 10 can also be used as a similar exciter (piezoelectric vibrating element) in a case where the piezoelectric film has a sufficient stretching and contracting force.

The vibration plate vibrated by the laminate of the piezoelectric film 10 is not limited, and various sheet-like materials (such as plate-like materials and films) can be used.

Examples thereof include a resin film consisting of polyethylene terephthalate (PET) and the like, foamed plastic consisting of foamed polystyrene and the like, a paper material such as a corrugated cardboard material, a glass plate, and wood. Further, a device such as a display device may be used as the vibration plate in a case where the device can be sufficiently bent.

It is preferable that the laminate of the piezoelectric film 10 according to the embodiment of the present invention is obtained by bonding adjacent piezoelectric films with a bonding layer (bonding agent). Further, it is preferable that the laminate of the piezoelectric film 10 and the vibration plate are also bonded to each other with a bonding layer.

The bonding layer is not limited, and various layers that can bond materials to be bonded can be used. Therefore, the bonding layer may consist of a pressure sensitive adhesive or an adhesive. It is preferable that an adhesive layer consisting of an adhesive is used from the viewpoint that a solid and hard bonding layer is obtained after the bonding.

The same applies to the laminate formed by folding back the long piezoelectric film 10 described later.

In the laminate of the piezoelectric films 10, the polarization direction of each piezoelectric film 10 to be laminated is not limited. As described above, the polarization direction of the piezoelectric film 10 is the polarization direction in the thickness direction.

Therefore, in the laminate of the piezoelectric films 10, the polarization directions may be the same for all the piezoelectric films 10, and piezoelectric films having different polarization directions may be present.

Here, in the laminate of the piezoelectric films 10, it is preferable that the piezoelectric films 10 are laminated such that the polarization directions of the adjacent piezoelectric films 10 are opposite to each other.

In the piezoelectric film 10, the polarity of the voltage to be applied to the piezoelectric layer 12 depends on the polarization direction of the piezoelectric layer 12. Therefore, even in a case where the polarization direction is directed from the first electrode layer 14 toward the second electrode layer 16 or from the second electrode layer 16 toward the first electrode layer 14, the polarity of the first electrode layer 14 and the polarity of the second electrode layer 16 in all the piezoelectric films 10 to be laminated are set to be the same as each other.

Therefore, by reversing the polarization directions of the adjacent piezoelectric films 10, even in a case where the electrode layers of the adjacent piezoelectric films 10 come into contact with each other, the electrode layers in contact with each other have the same polarity, and thus there is no risk of a short circuit.

The laminate of the piezoelectric film 10 may be configured such that the piezoelectric film 10 is folded back, for example, once or more times, or preferably a plurality of times to laminate a plurality of layers of the piezoelectric films 10.

The configuration in which the piezoelectric film 10 is folded back and laminated has the following advantages.

That is, in the laminate in which a plurality of cut sheet-like piezoelectric films 10 are laminated, the first electrode layer 14 and the second electrode layer 16 need to be connected to a driving power source for each piezoelectric film. On the contrary, in the configuration in which the long piezoelectric film 10 is folded back and laminated, only one sheet of the long piezoelectric film 10 can form the laminate. Further, in the configuration in which the long piezoelectric film 10 is folded back and laminated, only one power source is required for applying the driving voltage, and the electrode may be pulled out from the piezoelectric film 10 at one place.

Further, in the configuration in which the long piezoelectric film 10 is folded back and laminated, the polarization directions of the adjacent piezoelectric films 10 are inevitably opposite to each other.

Hereinbefore, the piezoelectric polymer film according to the embodiment of the present invention has been described in detail, but the present invention is not limited to the above-described examples, and various improvements or modifications may be made within a range not departing from the scope of the present invention.

Examples

Hereinafter, the piezoelectric polymer film of the present invention will be described in more detail with reference to specific examples of the present invention.

[Example 1]

Lead oxide powder, zirconium oxide powder, and titanium oxide powder were wet-mixed in a ball mill for 12 hours to prepare raw material mixed powder. Here, the amount of each oxide was set to Zr = 0.52 mol and Ti = 0.48 mol with respect to Pb = 1 mol.

This raw material mixed powder was put into a crucible and fired at 800°C for 5 hours, thereby preparing raw material particles of PZT particles.

PZT particles were prepared by pulverizing the prepared raw material particles with a typical ball mill.

The pulverization was performed with a ball mill under conditions of a media diameter of 1 mm, a filling rate of 30%, a rotation speed of 45 rpm, and a pulverization time of 15 hr.

A piezoelectric film as illustrated in Fig. 1 was prepared by the method illustrated in Figs. 2 to 4 using the prepared PZT particles.

First, cyanoethylated PVA (CR-V, manufactured by Shin-Etsu Chemical Co., Ltd.) was dissolved in dimethylformamide (DMF) at the following compositional ratio. Thereafter, the prepared PZT particles were added to the solution at the following compositional ratio, and the solution was stirred using a propeller mixer (rotation speed of 2000 rpm), thereby preparing a coating material for forming a piezoelectric layer.

- PZT Particles: 300 parts by mass
- Cyanoethylated PVA: 30 parts by mass
- DMF: 70 parts by mass

Further, two sheets of sheet-like materials obtained by performing vacuum vapor deposition on a copper thin film having a thickness of 0.1 $\mu$m was prepared on a PET film having a thickness of 4 $\mu$m. That is, in the present example, the first electrode layer and the second electrode layer are copper vapor deposition thin films having a thickness of 0.1 $\mu$m, and the first protective layer and the second protective layer are PET films having a thickness of 4 $\mu$m.

The second electrode layer (copper vapor deposition thin film) of one sheet of the sheet-like material was coated with the coating material for forming the piezoelectric layer prepared in advance using a slide coater. Further, the second electrode layer was coated the coating material such that the film thickness of the coating film after being dried reached 40 $\mu$m.

Next, the material obtained by coating the sheet-like material with the coating material was heated and dried on a hot plate at 120°C to evaporate DMF. In this manner, a laminate in which the second electrode layer made of copper was provided on the second protective layer made of PET and the piezoelectric layer having a thickness of 40 $\mu$m was provided thereon was prepared.

The prepared piezoelectric layer was subjected to a polarization treatment in the thickness direction.

The other sheet-like material was laminated on the laminate subjected to a polarization treatment in a state where the first electrode layer (copper thin film side) faced the piezoelectric composite material.

Next, a piezoelectric film as illustrated in Fig. 1 was prepared by performing thermal compression bonding on the laminate of the laminate and the sheet-like material at a temperature of 120°C using a laminator device, and bonding and adhering the piezoelectric composite material and the first electrode layer to each other.

A part of the prepared piezoelectric film was cut out, the first electrode layer was peeled off to expose the piezoelectric layer, and the Raman scattering light of the piezoelectric layer was measured to obtain a Raman spectrum.

First, the prepared piezoelectric film was cut with scissors into a size of $40 \times 40$ mm at an optional position. Further, an iron chloride aqueous solution was prepared by mixing a ferric chloride hexahydrate and pure water. The concentration of the iron chloride aqueous solution was set to 1.5 mol/L (liter).

The cut piezoelectric film was immersed while being hung in the prepared iron chloride aqueous solution for 12 hours. Thereafter, the immersed piezoelectric film was taken out and washed with pure water several times. A corner of the washed piezoelectric film was pinched, and the sheet-like material on the first electrode side was peeled off from the piezoelectric layer at a speed of approximately 4 mm/s to expose the piezoelectric layer. Further, the sheet-like material is a sheet obtained by performing vacuum vapor deposition on a copper thin film having a thickness of 0.1 $\mu$m, on a PET film having a thickness of 4 $\mu$m.

The piezoelectric film from which the first electrode layer had been peeled off was washed several times with pure water and naturally dried for 24 hours. The first electrode layer was peeled off from the piezoelectric film in the above-described manner, and the Raman scattering light of the exposed piezoelectric layer was measured to obtain a Raman spectrum.

Raman scattering light was measured using a Raman microscope with 532 nm excitation.

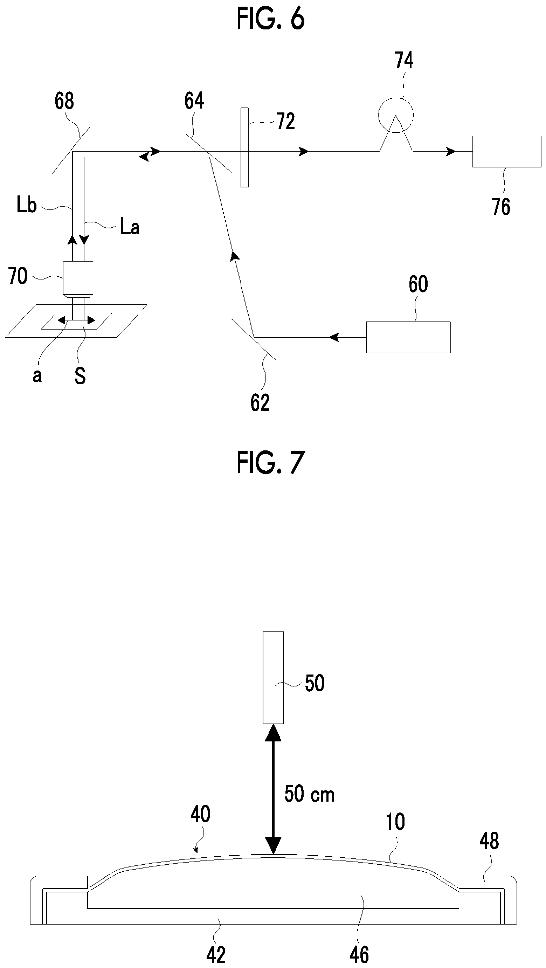

Fig. 6 conceptually illustrates a measurement system for Raman scattering light.

Laser light which was linearly polarized light (excitation light having a wavelength of 532 nm) emitted by a laser light source 60 was reflected by mirrors 62, 64, and 68, passed through an objective lens 70 at a magnification of 100 times, and was incident on the surface of a piezoelectric layer S as incident light La which is linearly polarized light (direction indicated by the arrow a).

Raman scattering light Lb due to the piezoelectric layer S passed through the objective lens 70, was reflected by the mirror 68, passed through the mirror 64, allowed a notch filter 72 to remove the excitation light, and was decomposed by a diffraction lattice 74 for each wavenumber, thereby performing photometry using a detector 76.

A Raman spectrum was obtained by performing a principal component analysis (PCA) treatment on the photometry results to remove noise and using components with an autocorrelation of 0.6 or greater.

Raman scattering light was measured by optionally selecting a region with an area of $40 \times 40$ $\mu$m on the surface of the piezoelectric layer exposed as described above and measuring 1,681 points of light in the region in steps of 1 $\mu$m under the conditions of 1 point of exposed light for 1 second.

The measurement was performed at two optional sites on the surface of the piezoelectric layer and an average of a total of 3362 spectra was calculated, thereby obtaining a Raman spectrum of the prepared piezoelectric layer. The Raman spectrum was created by performing baseline correction so that the intensity at 1000 cm$^{-1}$ reached 0 and using the baseline as a straight line with an intensity of 0.

As a result, the Raman shift of the maximum peak present in a range of 190 to 215 cm$^{-1}$ in the Raman spectrum of the piezoelectric layer was 197.8 cm$^{-1}$.

Further, the peak intensity ratio 1130/1110 of the peak intensity 1130 of the maximum peak present in a range of 120 to 150 cm$^{-1}$ to the peak intensity I100 of the maximum peak present in a range of 90 cm$^{-1}$ or greater and less than 120 cm$^{-1}$ was 1.236.

Further, the peak intensity ratio I725/I550 of the peak intensity I725 of the maximum peak present in a range of 700 cm$^{-1}$ to 750 cm$^{-1}$ to the peak intensity I550 of the maximum peak present in a range of 490 cm$^{-1}$ to 650 cm$^{-1}$ was 0.668.

Further, the particle diameter of the PZT particles in the piezoelectric layer was measured as described above.

The prepared piezoelectric film was cut in the thickness direction at an optional position. A cross section of the piezoelectric film in the thickness direction was observed with a scanning electron microscope, including the upper end and the lower end of the piezoelectric layer in the field of view, and the area ratio of the PZT particles in the piezoelectric layer was calculated by image-analyzing the image.

The area ratio of the PZT particles was divided by the number of PZT particles 26 in the microscopic image, and the particle diameter of the PZT particles 26 was calculated by converting the area into circles.

The measurement of the particle diameter of the PZT particles was performed on optionally selected five cross sections in the piezoelectric film, and the average value of the particle diameters of the five cross sections was defined as the particle diameter (arithmetic average diameter) of the PZT particles in the piezoelectric film. As a result, the particle diameter of the PZT particles was 3.3 $\mu$m.

[Example 2]

PZT particles were prepared in the same manner as in Example 1 except that the media diameter was changed to 0.5 mm and the pulverization time was changed to 24 hr in the pulverization of the raw material particles with a ball mill.
A piezoelectric film was prepared in the same manner as in Example 1 except that the PZT particles were used.
The particle diameter of the PZT particles, the Raman shift of the maximum peak present in a range of 190 to 215 cm$^{-1}$ in the Raman spectrum, the peak intensity ratio I130/I110, and the peak intensity ratio I725/ I550 were measured for the prepared piezoelectric film.
As a result, the particle diameter of the PZT particles was 10.7 $\mu$m, the Raman shift of the maximum peak was 199.2 cm$^{-1}$, the peak intensity ratio I130/I110 was 1.117, and the peak intensity ratio I725/I550 was 0.672.

[Example 3]

PZT particles were prepared in the same manner as in Example 1 except that the filling rate was changed to 50% and the pulverization time was changed to 10 hr in the pulverization of the raw material particles with a ball mill.
A piezoelectric film was prepared in the same manner as in Example 1 except that the PZT particles were used.
The particle diameter of the PZT particles, the Raman shift of the maximum peak present in a range of 190 to 215 cm$^{-1}$ in the Raman spectrum, the peak intensity ratio I130/I110, and the peak intensity ratio I725/ I550 were measured for the prepared piezoelectric film.
As a result, the particle diameter of the PZT particles was 3.5 $\mu$m, the Raman shift of the maximum peak was 204.1 cm$^{-1}$, the peak intensity ratio I130/I110 was 1.044, and the peak intensity ratio I725/I550 was 0.527.

[Example 4]

PZT particles were prepared in the same manner as in Example 1 except that the media diameter was changed to 0.5 mm, the filling rate was changed to 50%, and the rotation speed was changed to 60 rpm in the pulverization of the raw material particles with a ball mill.
A piezoelectric film was prepared in the same manner as in Example 1 except that the PZT particles were used.
The particle diameter of the PZT particles, the Raman shift of the maximum peak present in a range of 190 to 215 cm$^{-1}$ in the Raman spectrum, the peak intensity ratio I130/I110, and the peak intensity ratio I725/ I550 were measured for the prepared piezoelectric film.
As a result, the particle diameter of the PZT particles was 3.2 $\mu$m, the Raman shift of the maximum peak was 202.9 cm$^{-1}$, the peak intensity ratio 1130/1110 was 1.071, and the peak intensity ratio I725/I550 was 0.240.

[Comparative Example 1]

PZT particles were prepared in the same manner as in Example 1 except that the media diameter was changed to 30 mm and the pulverization time was changed to 22 hr in the pulverization of the raw material particles with a ball mill.
A piezoelectric film was prepared in the same manner as in Example 1 except that the PZT particles were used.
The particle diameter of the PZT particles, the Raman shift of the maximum peak present in a range of 190 to 215 cm$^{-1}$ in the Raman spectrum, the peak intensity ratio I130/I110, and the peak intensity ratio I725/ I550 were measured for the prepared piezoelectric film.
As a result, the particle diameter of the PZT particles was 3.4 $\mu$m, the Raman shift of the maximum peak was 212.4 cm$^{-1}$, the peak intensity ratio I130/I110 was 1.088, and the peak intensity ratio I725/I550 was 0.376.

[Comparative Example 2]

PZT particles were prepared in the same manner as in Example 1 except that the media diameter was changed to 10 mm and the pulverization time was changed to 18 hr in the pulverization of the raw material particles with a ball mill.
A piezoelectric film was prepared in the same manner as in Example 1 except that the PZT particles were used.
The particle diameter of the PZT particles, the Raman shift of the maximum peak present in a range of 190 to 215 cm$^{-1}$ in the Raman spectrum, the peak intensity ratio I130/I110, and the peak intensity ratio I725/ I550 were measured for the prepared piezoelectric film.
As a result, the particle diameter of the PZT particles was 3.2 $\mu$m, the Raman shift of the maximum peak was 209.0 cm$^{-1}$, the peak intensity ratio I130/I110 was 1.157, and the peak intensity ratio I725/I550 was 0.213.

[Comparative Example 3]

PZT particles were prepared in the same manner as in Example 1 except that the filling rate was changed to 50%, the rotation speed was changed to 60 rpm, and the pulverization time was changed to 12 hr in the pulverization of the raw material particles with a ball mill.

A piezoelectric film was prepared in the same manner as in Example 1 except that the PZT particles were used.

The particle diameter of the PZT particles, the Raman shift of the maximum peak present in a range of 190 to 215 $cm^{-1}$ in the Raman spectrum, the peak intensity ratio I130/I110, and the peak intensity ratio I725/ I550 were measured for the prepared piezoelectric film.

As a result, the particle diameter of the PZT particles was 3.2 $\mu$m, the Raman shift of the maximum peak was 206.1 $cm^{-1}$, the peak intensity ratio I130/I110 was 1.032, and the peak intensity ratio I725/I550 was 0.572.

[Comparative Example 4]

PZT particles were prepared in the same manner as in Example 1 except that the rotation speed was changed to 60 rpm and the pulverization time was changed to 12 hr in the pulverization of the raw material particles with a ball mill.

A piezoelectric film was prepared in the same manner as in Example 1 except that the PZT particles were used.

The particle diameter of the PZT particles, the Raman shift of the maximum peak present in a range of 190 to 215 $cm^{-1}$ in the Raman spectrum, the peak intensity ratio I130/I110, and the peak intensity ratio I725/ I550 were measured for the prepared piezoelectric film.

As a result, the particle diameter of the PZT particles was 3.1 $\mu$m, the Raman shift of the maximum peak was 207.8 $cm^{-1}$, the peak intensity ratio I130/I110 was 1.140, and the peak intensity ratio I725/I550 was 0.434.

[Evaluation]

[Preparation of piezoelectric speaker and measurement of sound pressure]

The piezoelectric speaker illustrated in Fig. 5 was prepared using the prepared piezoelectric film.

First, a rectangular test piece having a size of 210 × 300 mm (A4 size) was cut out from the prepared piezoelectric film. The cut-out piezoelectric film was placed on a 210 × 300 mm case in which glass wool serving as a viscoelastic support was stored in advance as illustrated in Fig. 5, and the peripheral portion was pressed by a frame to impart an appropriate tension and an appropriate curvature to the piezoelectric film, thereby preparing a piezoelectric speaker as illustrated in Fig. 5.

The depth of the case was set to 9 mm, the density of glass wool was set to 32 kg/m$^3$, and the thickness before assembly was set to 25 mm.

A 1 kHz sine wave was input to the prepared piezoelectric speaker as an input signal through a power amplifier, and the sound pressure was measured with a microphone 50 placed at a distance of 50 cm from the center of the speaker as conceptually illustrated in Fig. 7.

The results are listed in the table below.

[Table 1]

| | Media diameter [mm] | Filling rate [%] | Rotation speed [rpm] | Pulverization time [hr] | PZT Particle diameter [μm] | Raman spectrum | | | Sound pressure [dB] |
|---|---|---|---|---|---|---|---|---|---|
| | | | | | | Raman shift | I130/I100 | I725/I550 | |
| Example 1 | 1 | 30 | 45 | 15 | 3.3 | 197.8 | 1.236 | 0.668 | 88.4 |
| Example 2 | 0.5 | 30 | 45 | 24 | 10.7 | 199.2 | 1.117 | 0.672 | 87.1 |
| Example 3 | 1 | 50 | 45 | 10 | 3.5 | 204.1 | 1.044 | 0.527 | 76.5 |
| Example 4 | 0.5 | 50 | 60 | 15 | 3.2 | 202.9 | 1.071 | 0.24 | 73.1 |
| Comparative Example 1 | 30 | 30 | 45 | 22 | 3.4 | 212.4 | 1.088 | 0.376 | 53.3 |
| Comparative Example 2 | 10 | 30 | 45 | 18 | 3.2 | 209 | 1.157 | 0.213 | 62.9 |
| Comparative Example 3 | 1 | 50 | 60 | 12 | 3.2 | 206.1 | 1.032 | 0.572 | 69 |
| Comparative Example 4 | 1 | 30 | 60 | 12 | 3.1 | 207.8 | 1.14 | 0.434 | 68.7 |

In the table, the Raman shift denotes a Raman shift of the maximum peak [$cm^{-1}$] present in a range of 190 to 215 $cm^{-1}$.

As listed in Table 1, all the piezoelectric films of the present invention in which the Raman shift of the maximum peak present in a range of 190 to 215 $cm^{-1}$ in the Raman spectrum of the piezoelectric layer was 205 $cm^{-1}$ or less output a high sound pressure of 70 dB or greater. In other words, it was found that the piezoelectric film of the present invention had satisfactory piezoelectric characteristics.

Further, based on the comparison between Example 1 and Example 2, a high sound pressure was able to be obtained by setting the particle diameter of the PZT particles to be in a range of 1 to 10 $\mu$m. Based on the comparison between Example 1 and Example 3, a high sound pressure was able to be obtained by setting the peak intensity ratio 1130/1110 to 1.05 or greater. Further, based on the comparison between Example 1 and Example 4, a high sound pressure was able to be obtained by setting the peak intensity ratio I725/I550 to 0.25 or greater.

On the contrary, all the piezoelectric films of the comparative examples, in which the Raman shift of the maximum peak present in a range of 190 to 215 $cm^{-1}$ in the Raman spectrum of the piezoelectric layer was greater than 205 $cm^{-1}$ had a sound pressure of less than 70 dB.

Further, in the piezoelectric films of Examples 1, 3, and 4 and the piezoelectric films of Comparative Examples 1 to 4, the particle diameters of PZT particles were all in a range of 3.1 to 3.5 $\mu$m, which were similar to each other.

However, in regard to the Raman shift of the maximum peak present in a range of 190 to 215 $cm^{-1}$ in the Raman spectrum of the piezoelectric layer, the Raman shift of each piezoelectric film in Examples 1, 3, and 4 was 205 $cm^{-1}$ or less. On the contrary, the Raman shift of each piezoelectric film of Comparative Examples 1 to 4 was greater than 205 $cm^{-1}$.

That is, in Examples 1, 3, and 4, and Comparative Examples 1 to 4, it was found that the media diameter, the media filling rate, the rotation speed, and the pulverization time were required to be appropriately set during the pulverization with a ball mill in order to obtain PZT particles having a desired particle diameter and to set the Raman shift of the maximum peak present in a range of 190 to 215 $cm^{-1}$ in the Raman spectrum of the piezoelectric layer to 205 $cmn^{-1}$ or less.

As shown in the results described above, the effects of the present invention are apparent.

The present invention can be suitably used for electroacoustic transducers such as speakers, vibration sensors, and the like.

Explanation of References

| | |
|---|---|
| 10: | piezoelectric (polymer) film |
| 12: | piezoelectric layer |
| 14: | first electrode layer |
| 16: | second electrode layer |
| 18: | first protective layer |
| 20: | second protective layer |
| 24: | matrix |
| 26: | PZT particle |
| 34, 38: | sheet-like material |
| 36: | laminate |
| 40: | piezoelectric speaker |
| 42: | case |
| 46: | viscoelastic support |
| 48: | frame |
| 50: | microphone |
| 60: | laser light source |
| 62, 64, 68: | mirror |
| 70: | objective lens |
| 72: | notch filter |
| 74: | diffraction lattice |
| 76: | detector |

**Claims**

1. A piezoelectric polymer film (10) comprising:

a piezoelectric layer (12) containing lead zirconate titanate particles (26) in a matrix (24) that contains a polymer material; and

an electrode layer (14, 16) provided on each of both surfaces of the piezoelectric layer (12),

**characterized in that**

a Raman shift of a maximum peak present in a range of 190 to 215 cm$^{-1}$ in a Raman spectrum of the piezoelectric layer is 205 cm$^{-1}$ or less; and

wherein in a case where a peak intensity of a maximum peak present in a range of 490 to 650 cm$^{-1}$ is defined as I550 and a peak intensity of a maximum peak present in a range of 700 to 750 cm$^{-1}$ is defined as I725 in the Raman spectrum of the piezoelectric layer (12), a peak intensity ratio I725/I550 is 0.25 or greater.

2. The piezoelectric polymer film (10) according to claim 1, further comprising:
   a protective layer (18, 20) covering the electrode layer (14, 16).

3. The piezoelectric polymer film (10) according to claim 1 or 2,
   wherein the lead zirconate titanate particles have an arithmetic average diameter of 1 to 10 $\mu$m.

4. The piezoelectric polymer film (10) according to any one of claims 1 to 3,
   wherein in a case where a peak intensity of a maximum peak present in a range of 90 cm$^{-1}$ or greater and less than 120 cm$^{-1}$ is defined as I100 and a peak intensity of a maximum peak present in a range of 120 to 150 cm$^{-1}$ is defined as I130, in the Raman spectrum of the piezoelectric layer, a peak intensity ratio I130/I110 is 1.05 or greater.

5. The piezoelectric polymer film (10) according to any one of claims 1 to 4,
   wherein the polymer material contains a cyanoethyl group.

6. The piezoelectric polymer film (10) according to claim 5,
   wherein the polymer material is cyanoethylated polyvinyl alcohol.

7. The piezoelectric polymer film (10) according to any one of claims 1 to 6,
   wherein the piezoelectric layer (12) is polarized in a thickness direction.


**Patentansprüche**

1. Piezoelektrischer Polymerfilm (10), umfassend:

   eine piezoelektrische Schicht (12), die Bleizirkonattitanat-Partikel (26) in einer Matrix (24), die ein Polymermaterial enthält, enthält; und
   eine Elektrodenschicht (14, 16), die auf jeder von beiden Oberflächen der piezoelektrischen Schicht (12) vorgesehen ist,

   **dadurch gekennzeichnet, dass**
   eine Raman-Verschiebung einer Maximalspitze, die in einem Bereich von 190 bis 215 cm$^{-1}$ in einem Raman-Spektrum der piezoelektrischen Schicht vorhanden ist, 205 cm$^{-1}$ oder weniger beträgt; und
   wobei in einem Fall, in dem in dem Raman-Spektrum der piezoelektrischen Schicht (12) eine Spitzenintensität einer Maximalspitze, die in einem Bereich von 490 bis 650 cm$^{-1}$ vorhanden ist, als I550 definiert ist und eine Spitzenintensität einer Maximalspitze, die in einem Bereich von 700 bis 750 cm$^{-1}$ vorhanden ist, als I725 definiert ist, ein Spitzenintensitätsverhältnis I725/I550 0,25 oder größer ist.

2. Piezoelektrischer Polymerfilm (10) nach Anspruch 1, ferner umfassend:
   eine Schutzschicht (18, 20), die die Elektrodenschicht (14, 16) abdeckt.

3. Piezoelektrischer Polymerfilm (10) nach Anspruch 1 oder 2,
   wobei die Bleizirkonattitanat-Partikel einen arithmetischen durchschnittlichen Durchmesser von 1 bis 10 $\mu$m auf-weisen.

4. Piezoelektrischer Polymerfilm (10) nach einem der Ansprüche 1 bis 3,
   wobei in einem Fall, in dem in dem Raman-Spektrum der piezoelektrischen Schicht eine Spitzenintensität einer Maximalspitze, die in einem Bereich von 90 cm$^{-1}$ oder größer und kleiner als 120 cm$^{-1}$ vorhanden ist, als I100 definiert ist und eine Spitzenintensität einer Maximalspitze, die in einem Bereich von 120 bis 150 cm$^{-1}$ vorhanden ist, als I130 definiert ist, ein Spitzenintensitätsverhältnis I130/I110 1,05 oder größer ist.

5. Piezoelektrischer Polymerfilm (10) nach einem der Ansprüche 1 bis 4,
   wobei das Polymermaterial eine Cyanoethylgruppe enthält.

6. Piezoelektrischer Polymerfilm (10) nach Anspruch 5,
   wobei das Polymermaterial cyanoethylierter Polyvinylalkohol ist.

7. Piezoelektrischer Polymerfilm (10) nach einem der Ansprüche 1 bis 6,
   wobei die piezoelektrische Schicht (12) in einer Dickenrichtung polarisiert ist.

**Revendications**

1. Film polymère piézoélectrique (10) comprenant :

   une couche piézoélectrique (12) contenant des particules de titanate de zirconate de plomb (26) dans une matrice (24) qui contient un matériau polymère ; et
   une couche d'électrode (14, 16) prévue sur chacune des deux surfaces de la couche piézoélectrique (12),
   **caractérisé en ce que**
   un décalage Raman d'un pic maximal présent dans une plage de 190 à 215 cm$^{-1}$ dans un spectre Raman de la couche piézoélectrique est de 205 cm$^{-1}$ ou moins; et
   dans lequel dans un cas où une intensité de pic d'un pic maximal présent dans une plage de 490 à 650 cm$^{-1}$ est définie comme I550 et une intensité de pic d'un pic maximal présent dans une plage de 700 à 750 cm$^{-1}$ est définie comme I725 dans le spectre Raman de la couche piézoélectrique (12), un rapport d'intensité de pic I725/I550 est de 0,25 ou supérieur.

2. Film polymère piézoélectrique (10) selon la revendication 1, comprenant en outre :
   une couche protectrice (18, 20) recouvrant la couche d'électrode (14, 16).

3. Film polymère piézoélectrique (10) selon la revendication 1 ou la revendication 2,
   dans lequel les particules de titanate de zirconate de plomb ont un diamètre moyen arithmétique de 1 à 10 $\mu$m.

4. Film polymère piézoélectrique (10) selon l'une quelconque des revendications 1 à 3,
   dans laquelle dans un cas où une intensité de pic d'un pic maximal présent dans une plage de 90 cm$^{-1}$ ou supérieur et inférieure à 120 cm$^{-1}$ est définie comme I100 et une intensité de pic d'un pic maximal présent dans une plage de 120 à 150 cm$^{-1}$ est définie comme I130, dans le spectre Raman de la couche piézoélectrique, un rapport d'intensité de pic I130/I110 est de 1,05 ou supérieur.

5. Film polymère piézoélectrique (10) selon l'une quelconque des revendications 1 à 4,
   dans lequel le matériau polymère contient un groupe cyanoéthyle.

6. Film polymère piézoélectrique (10) selon la revendication 5,
   dans lequel le matériau polymère est de l'alcool polyvinylique cyanoéthylé.

7. Film polymère piézoélectrique (10) selon l'une quelconque des revendications 1 à 6,
   dans lequel la couche piézoélectrique (12) est polarisée dans une direction d'épaisseur.

# FIG. 1

# FIG. 2

## FIG. 3

## FIG. 4

## FIG. 5

## FIG. 6

## FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014212307 A
- US 2016014526 A1
- WO 2020261822 A1
- WO 2020261954 A
- US 2018014096 A1